# EUROPEAN PATENT SPECIFICATION

(11) **EP 1 992 588 B1**
(45) Date of publication and mention of the grant of the patent: **07.12.2016**
(21) Application number: 07255071.8
(22) Date of filing: 28.12.2007
(51) Int. Cl.: B81B 7/00, H05K 1/18, H04R 19/04

(54) **Packaging of MEMS microphone**
Verkapselung eines MEMS-Mikrofons
Encapsulation de microphone MEMS

(30) Priority: 15.05.2007 TW 96117297
(43) Date of publication of application: 19.11.2008
(73) Proprietor: Industrial Technology Research Institute, Chutung Hsinchu 31040 (TW)
(72) Inventor: Huang, Chao-Ta, East District Hsinchu City 300 (TW); Chien, Hsin-Tang, Luodong Town Yilan County 265 (TW)
(74) Representative: Becker, Eberhard

(56) References cited:
- EP-A2- 1 569 498
- WO-A1-2007/032580
- DE-B3-102004 011 148
- US-A1- 2007 013 036
- US-A1- 2007 058 826
- US-B1- 6 594 369

## Description

### Field of the Invention

The present invention relates to a microelectromechanical system (MEMS) microphone. More particularly, the present invention relates to a package and a packaging assembly of the MEMS microphone.

### Description of Related Art

Along with the increasing demands for mobile phones, requirements relating to acoustic quality of mobile phones, and maturity of hearing aid technology, the demand for high-quality mini-microphone is rapidly growing. Capacitor microphones which are fabricated by MEMS technology have advantages of light weight, small volume, and good signal quality, so MEMS microphones have gradually become mainstream products of the mini-microphone.

A "Microelectromechanical system package with environmental and interference shield" has been disclosed in US patent No. US 6,781,231, which includes a MEMS microphone, a substrate, and a cover. The substrate has a surface for carrying the MEMS microphone. The cover includes a conductive layer having a central portion and a peripheral portion around the central portion. The peripheral portion of the cover is connected to the substrate to form a housing. The central portion of the cover and the substrate are separated by a space for accommodating the

US 2007/013036 A1 discloses a MEMS package and a method for its forming. The MEMS package has at least one MEMS device located on a flexible substrate. A metal structure surrounds the at least one MEMS device wherein a bottom surface of the metal structure is attached to the flexible substrate and wherein a portion of the flexible substrate is folded over a top surface of the metal structure and attached to the top surface of the metal structure thereby forming the MEMS package.

US 2007/058826 A1 discloses a microphone element having a diaphragm and a fixed electrode disposed opposite to each other on a silicon board having a central opening portion. The microphone element is mounted and fixed onto a base board having a sound hole. A perimeter-shaped side board and a cover board are mounted and fixed onto the board, thereby forming a back cavity on an upper side of the microphone element. The diaphragm and the fixed electrode are conducted to conductive layers of the cover board through conductive layers of the base board, and a conductive layer and a coiled spring in the side board respectively, and mounting on a surface of a printed board of an external apparatus can be carried out in a conductive layer on an upper surface thereof.

US 6 594 369 B1 discloses an electret capacitor microphone which is constituted by a surface conductive diaphragm, a fixed electrode provided opposite to the diaphragm at a regular interval and a solid state device for converting, into an electric signal, a voice given to the diaphragm with a change in an electrostatic capacity between the diaphragm and the fixed electrode. The microphone comprises a dielectric casing having a bottomed hollow portion for accommodating the diaphragm, the fixed electrode and the solid state device.

EP 1 569 498 A2 discloses a surface mount parallelepiped condenser microphone. In the surface mount parallelepiped condenser microphone, a case has a rectangular box shape with an opening, a backplate has a circular shape with a sound hole, a spacer has thin ring shape, an insulation ring has a hollow cylindrical shape with top and bottom openings, a diaphragm faces the backplate with disposing the spacer therebetween, and a PCB has a rectangular shape with a sound hole at a center portion, the PCB being electrically connected with the diaphragm through a conductive ring, wherein a metal ring, the backplate, the spacer, the insulation ring, the diaphragm, the conductive ring, and the PCB are sequentially disposed in the case (102).

WO 2007/032580 A1 discloses a silicon based condenser microphone comprising: a metal case which is a sound hole: a board which is mounted with a MEMS microphone chip and an ASIC chip having a electric pressure pump and a buffer IC and is formed with a connecting pattern for joining with the metal case; a fixing means for fixing the metal case to the board; and an adhesive for applying to the whole part where the metal case fixed to the board by the fixing means is joined with the board to bond the metal case to the board.

Accordingly, the present invention is directed to a package of MEMS microphone, adapted to be mounted on the printed circuit board for converting an acoustic signal to an electronic signal.

The present invention is also directed to a packaging assembly of the MEMS microphone, for converting the acoustic signal to the electronic signal.

The present invention provides a package of the MEMS microphone including a cover and at least one MEMS microphone. The cover has an inner surface and a conductive trace disposed on the inner surface. The MEMS microphone is mounted on the inner surface of the cover and is electrically connected with the conductive trace. When the cover is assembled to a printed circuit board, the cover and the printed circuit board construct an acoustic housing.

The present invention provides a packaging assembly of the MEMS microphone including a cover, at least one MEMS microphone, and a printed circuit board. The cover has an inner surface, and a conductive trace disposed on the inner surface. The MEMS microphone is mounted on the inner surface of the cover, and is electrically connected to the conductive trace. The printed circuit board allows the cover to be assembled thereon, and construct an acoustic housing with the cover.

In the present invention, the cover is used to carry the MEMS microphone, and is connected to the printed circuit board, and the cover and the printed circuit board construct or provide an acoustic housing for accommodating the MEMS microphone.

In order to make the aforementioned and other features and advantages of the present invention comprehensible, embodiments accompanied with figures are described in detail below.

It is to be understood that both the foregoing general description and the following detailed description are exemplary, and are intended to provide further explanation of the invention as claimed.

The accompanying drawings are included to provide a further understanding of the invention, and are incorporated in and constitute a portion of this specification. The drawings are schematic and illustrate embodiments of the invention and, together with the description, serve to explain the principles of the invention.
FIG 1 is a cross sectional view of a package of a MEMS microphone ;
FIG 2 is a partial cross-sectional view of the package of the MEMS microphone of FIG 1 assembled to a printed circuit board;
FIG. 3 is a partial cross-sectional view of a package of a MEMS microphone assembled to a printed circuit board according to another embodiment of the present invention;
FIG 4 is a partial cross-sectional view of a package of a MEMS microphone assembled to a printed circuit board according to still another embodiment of the present invention; and
FIG 5 is a partial cross-sectional view of a package of a MEMS microphone assembled to a printed circuit board according to yet another embodiment of the present invention.

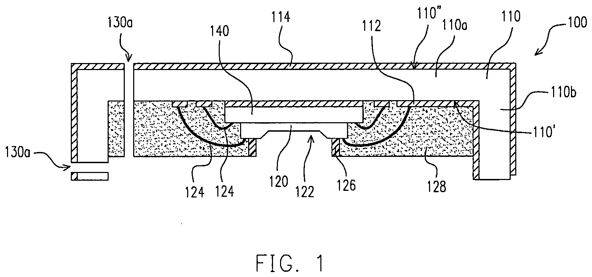

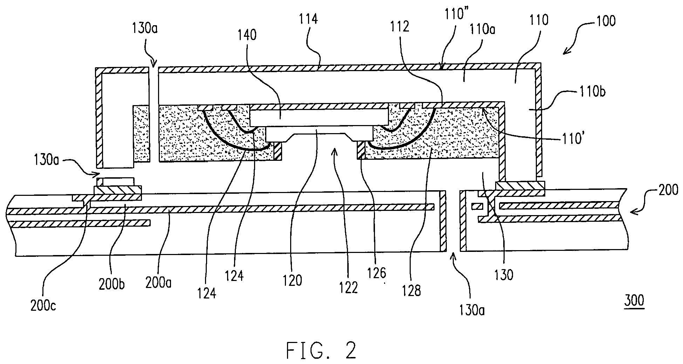

FIG. 1 is a cross-sectional view of a package of a MEMS microphone, and FIG. 2 is a partial cross-sectional view of the package of the MEMS microphone of FIG. 1 assembled to a printed circuit board. Referring to FIGs. 1 and 2 together, the package of the MEMS microphone (hereafter referred to as the package) 100 of this embodiment is adapted to be assembled with a printed circuit board 200, in which the printed circuit board 200 includes a plurality of conductive layers 200a, a plurality of dielectric layers 200b stacked alternately with the conductive layers 200a, and a plurality of conductive vias 200c passing through the dielectric layers 200b and electrically connected with the conductive layers 200a.

The package 100 includes a cover 110 which can be fabricated by or from plastic material or ceramic material. The cover 110 has an inner surface 110' and a conductive trace 112 disposed on the inner surface 110'. The conductive trace 112 can be fabricated by firstly forming a metal film on the inner surface 110' of the cover 110 through a coating technology, and then patterning the metal film to form the conductive trace 112 through an etching technology.

The package 100 further includes a MEMS microphone 120 disposed on the inner surface 110' of the cover 110 and electrically connected to the conductive trace 112, and has an acoustic pressure receiving surface 122. In this embodiment, the MEMS microphone 120 can be adhered onto the inner surface 110' of the cover 110, and electrically connected to the conductive trace 112 of the cover 110 through wire bonding. When the MEMS microphone 120 is electrically connected to the conductive trace 112 of the cover 110 through a plurality of wires 124, a dam bar 126 is formed on the MEMS microphone 120, and an encapsulant 128 is formed in a scope or volume surrounded by the cover 110 and the dam bar 126 through an encapsulation technology, so as to protect the MEMS microphone 120 and the wires 124.

When the cover 110 is assembled to the printed circuit board 200, the cover 110 and the printed circuit board 200 construct an acoustic housing 130, in which the acoustic housing 130 has one or more acoustic hole(s) 130a, which respectively pass through the cover 110 and the printed circuit board 200. In this embodiment, the cover 110 has a top wall 110a and a sidewall 110b located around the top wall 110a and substantially surrounding the top wall 110a, in which the shape of a space formed by the top wall 110a and the sidewall 110b can be a cuboid or a cylinder, and the acoustic hole(s) 130a respectively penetrate through the top wall 110a and the sidewall 110b. In addition, the acoustic holes 130a can be formed in the cover 110 and the printed circuit board 200 through a drilling technology.

The package 100 further includes an integrated circuit chip (IC chip) 140 mounted on the inner surface 110' of the cover 110, electrically connected with the conductive trace 112, and located in the acoustic housing 130. The MEMS microphone 120 is disposed on the IC chip 140. In this embodiment, the MEMS microphone 120 can be adhered on the IC chip 140, and the IC chip 140 can be electrically connected to the conductive trace 112 of the cover 110 by wire bonding. The cover 110 can further have a conductive layer 114 disposed on an outer surface 110" opposite to the inner surface 110' thereof. When the cover 110 is assembled to the printed circuit board 200, the conductive layer 114 is electrically connected to one of the conductive layer 200a of the printed circuit board 200, and forms a shield together with the conductive layer 200a so as to prevent electromagnetic waves from interfering with the MEMS microphone 120 and the IC chip 140. In this embodiment, coating technology can be used to form the conductive layer 114 on the outer surface 110" of the cover.

When the cover 110 is assembled to the printed circuit board 200, the package 100 and the printed circuit board 200 constructs a packaging assembly of a MEMS microphone 300.

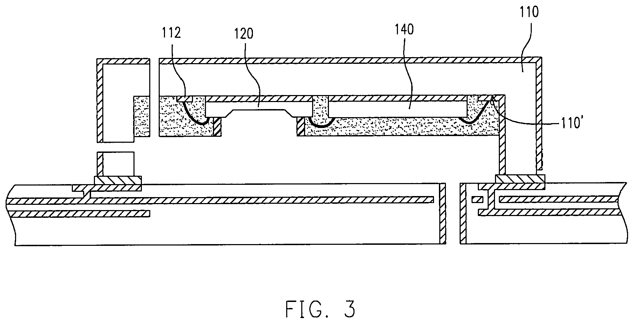

FIG. 3 is a partial cross-sectional view of a package of a MEMS microphone assembled to the printed circuit board according to another embodiment of the present invention. Referring to FIG 3, the MEMS microphone 120 can also be directly disposed on the inner surface 110' of the cover 110, and the MEMS microphone 120 can be electrically connected to the IC chip 140, and can be electrically connected with the conductive trace 112 on the inner surface 110' of the cover 110. In addition, the IC chip 140 can also be directly disposed on the inner surface 110' of the cover 110, and the IC chip 140 can be electrically connected with the conductive trace 112 on the inner surface 110' of the cover 110.

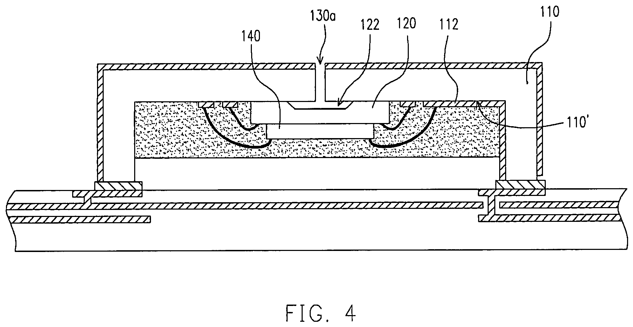

FIG 4 is a partial cross-sectional view of a package of a MEMS microphone assembled to the printed circuit board according to still another embodiment of the present invention. Referring to FIG. 4, one side of the MEMS microphone 120 having an acoustic pressure receiving surface 122 is directly disposed on the inner surface 110' of the cover 110. The acoustic hole 130a passes through the cover 110 to allow the acoustic pressure receiving surface 122 to communicate with the outside. The MEMS microphone 120 can be electrically connected with the conductive trace 112 on the inner surface 110' of the cover 110. In addition, the IC chip 140 can also be directly disposed on the MEMS microphone 120, and can be electrically connected with the conductive trace 112 on the inner surface 110' of the cover 110.

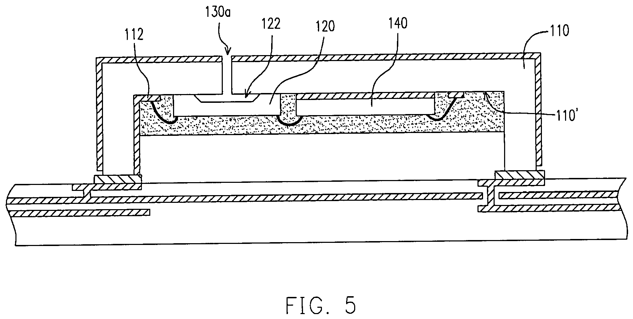

FIG 5 is a partial cross-sectional view of a package of a MEMS microphone assembled to the printed circuit board according to yet another embodiment of the present invention. Referring to FIG. 5, one side of the MEMS microphone 120 having the acoustic pressure receiving surface 122 is directly disposed on the inner surface 110' of the cover 110. The acoustic hole 130a passes through the cover 110 to allow the acoustic pressure receiving surface 122 to communicate with the outside. The MEMS microphone 120 can be electrically connected to the IC chip 140, and can be electrically connected with the conductive trace 112 on the inner surface 110' of the cover 110. In addition, the IC chip 140 can also be directly disposed on the inner surface 110' of the cover 110, and the IC chip 140 can be electrically connected with the conductive trace 112 on the inner surface 110' of the cover 110.

To sum up, the present invention uses the cover to carry the MEMS microphone and to connect to the printed circuit board. The cover and the printed circuit board form an acoustic housing, so as to accommodate the MEMS microphone therein. Therefore, the present invention can be used to package the MEMS microphone, and can be used in conjunction with the printed circuit board to provide the acoustic housing for the MEMS microphone, so as to facilitate the MEMS microphone to convert the acoustic signal to the electronic signal.

It will be apparent to those skilled in the art that various modifications and variations can be made to the structure of the present invention without departing from the scope of the invention. In view of the foregoing, it is intended that the present invention cover modifications and variations of this invention provided they fall within the scope of the following claims.

## Claims

1. A package of a microelectromechanical system (MEMS) microphone (100), comprising:
a cover (110) having an inner surface (110') and a conductive trace (112) disposed on the inner surface (110'), wherein the cover (110) has a top wall (110a) and a sidewall (110b) located around the top wall (110a) and substantially surrounds the top wall (110a);
at least one MEMS microphone (120) mounted on the inner surface (110') of the cover (110) and electrically connected with the conductive trace (112), wherein the MEMS microphone (120) has an acoustic pressure receiving surface (122);
a printed circuit board (200); wherein
the cover (110) is assembled to the printed circuit board (200); and
the cover (110) and the printed circuit board (200) construct an acoustic housing (130) having at least one acoustic hole (130a) passing through the cover (110);
and, at least one IC chip (140) mounted on the inner surface (110') of the cover (110), electrically connected with the conductive trace (112) and located in the acoustic housing (130); **characterized in that**
the printed circuit board (200) forms a bottom of the acoustic housing (130); and
the conductive trace (112) extends from the top wall (110a) along the sidewall (110b) and is electrically connected to the printed circuit board (200).

2. The package of the MEMS microphone (100) as claimed in claim 1, wherein the cover (110) has a conductive layer (114) disposed on an outer surface opposite to the inner surface thereof and electrically connected to a conductive layer (200a) of the printed circuit board (200).

3. The package of the MEMS microphone (100) as claimed in claim 1, wherein a shape formed by the top wall and the sidewall is a cuboid or a cylinder.

4. The package of the MEMS microphone (100) as claimed in claim 1, wherein the MEMS microphone (120) is mounted on the inner surface of the cover (110) via the IC chip (140).

5. The package of the MEMS microphone (100) as claimed in claim 1, wherein the MEMS microphone (120) is electrically connected to the IC chip (140).

6. The package of the MEMS microphone (100) as claimed in claim 1, wherein the at least one IC chip (140) located in the acoustic housing (130) is mounted on the inner surface of the cover (110) via the MEMS microphone (120).

7. The package of the MEMS microphone (100) as claimed in claim 1, wherein the printed circuit board (200) has at least one acoustic hole (130a) passing through the printed circuit board (200).

## Patentansprüche

1. Packung eines mikroelektromechanischen System(MEMS)-Mikrofons (100), umfassend:
eine Abdeckung (110) mit einer inneren Fläche (110') und einer leitfähigen Spur (112), die an der inneren Fläche (110') angeordnet ist, wobei die Abdeckung (110) eine obere Wand (110a) und eine Seitenwand (110b) aufweist, die sich um die obere Wand (110a) herum befindet und die obere Wand (110a) im Wesentlichen umgibt;
wenigstens ein MEMS-Mikrofon (120), das an der inneren Fläche (110') der Abdeckung (110) angebracht ist und elektrisch mit der leitfähigen Spur (112) verbunden ist, wobei das MEMS-Mikrofon (120) eine Schalldruckempfängsfläche (122) aufweist;
eine gedruckte Leiterplatte (200); wobei
die Abdeckung (110) mit der gedruckten Leiterplatte (200) zusammengebaut ist; und
die Abdeckung (110) und die gedruckte Leiterplatte (200) ein Schallgehäuse (130) konstruieren, das wenigstens ein Schallloch (130a) aufweist, das durch die Abdeckung (110) verläuft; und
wenigstens einen IC-Chip (140), der an der inneren Fläche (110') der Abdeckung (110) angebracht ist, elektrisch mit der leitfähigen Spur (112) verbunden ist und sich in dem Schallgehäuse (130) befindet; **dadurch gekennzeichnet, dass**
die gedruckte Leiterplatte (200) einen Boden des Schallgehäuses (130) bildet; und
die leitfähige Spur (112) sich von der oberen Wand (110a) entlang der Seitenwand (110b) erstreckt und elektrisch mit der gedruckten Leiterplatte (200) verbunden ist.

2. Packung des MEMS-Mikrofons (100) gemäß Anspruch 1, wobei die Abdeckung (110) eine leitfähige Schicht (114) aufweist, die an einer äußeren Fläche gegenüber der inneren Fläche davon angeordnet ist und elektrisch mit einer leitfähigen Schicht (200a) der gedruckten Leiterplatte (200) verbunden ist.

3. Packung des MEMS-Mikrofons (100) gemäß Anspruch 1, wobei eine Form, die durch die oberen Wand und die Seitenwand gebildet wird, ein Quader oder eine Zylinder ist.

4. Packung des MEMS-Mikrofons (100) gemäß Anspruch 1, wobei das MEMS-Mikrofon (120) über den IC-Chip (140) an einer inneren Fläche der Abdeckung (110) angebracht ist.

5. Packung des MEMS-Mikrofons (100) gemäß Anspruch 1, wobei da MEMS-Mikrofon (120) elektrisch mit dem IC-Chip (140) verbunden ist.

6. Packung des MEMS-Mikrofons (100) gemäß Anspruch 1, wobei der wenigstens eine IC-Chip (140), der sich in dem Schallgehäuse (130) befindet, über das MEMS-Mikrofon (120) an der inneren Fläche des Gehäuses (110) angebracht ist.

7. Packung des MEMS-Mikrofons (100) gemäß Anspruch 1, wobei die gedruckte Leiterplatte (200) wenigstens ein Schallloch (130a) aufweist, das durch die gedruckte Leiterplatte (200) verläuft.

## Revendications

1. Encapsulation d'un microphone (100) de système microélectromécanique (MEMS), comprenant :
un couvercle (110) ayant une surface intérieure (110') et une piste conductrice (112) disposée sur la surface intérieure (110'), dans laquelle le couvercle (110) a une paroi de sommet (110a) et une paroi latérale (110b) située autour de la paroi de sommet (110a) et entoure substantiellement la paroi de sommet (110a) ;
au moins un microphone MEMS (120) monté sur la surface intérieure (110') du couvercle (110) et connecté électriquement à la piste conductrice (112), dans laquelle le microphone MEMS (120) a une surface de réception de pression acoustique (122) ;
une carte de circuit imprimé (200) ;
dans laquelle
le couvercle (110) est assemblé à la carte de circuit imprimé (200) ; et
le couvercle (110) et la carte de circuit imprimé (200) construisent un boîtier acoustique (130) ayant au moins un trou acoustique (130a) passant à travers le couvercle (110) ;
au moins une puce de circuit intégré (140) montée sur la surface intérieure (110') du couvercle (110), connectée électriquement avec la piste conductrice (112) et située dans le boîtier acoustique (130) ; **caractérisée en ce que**
la carte de circuit imprimé (200) forme une base du boîtier acoustique (130) ; et
la piste conductrice (112) s'étend de la paroi de sommet (110a) le long de la paroi latérale (110b) et est connectée électriquement à la carte de circuit imprimé (200).

2. Encapsulation de microphone MEMS (100) selon la revendication 1, dans laquelle la couvercle (110) possède une couche conductrice (114) disposée sur une surface extérieure opposée à la surface intérieure de ce dernier et connectée électriquement à une couche conductrice (200a) de la carte de circuit imprimé (200).

3. Encapsulation de microphone MEMS (100) selon la revendication 1, dans laquelle une forme formée par la paroi de sommet et la paroi latérale est un cuboïde ou un cylindre.

4. Encapsulation de microphone MEMS (100) selon la revendication 1, dans laquelle le microphone MEMS (120) est monté sur la surface intérieure du couvercle (110) via la puce de circuit imprimé (140).

5. Encapsulation de microphone MEMS (100) selon la revendication 1, dans laquelle le microphone MEMS (120) est connecté électriquement à la puce de circuit imprimé (140).

6. Encapsulation de microphone MEMS (100) selon la revendication 1, dans laquelle au moins une puce de circuit imprimé (140) située dans le boîtier acoustique (130) est montée sur la surface intérieure du couvercle (110) via le microphone MEMS (120).

7. Encapsulation de microphone MEMS (100) selon la revendication 1, dans laquelle la carte de circuit imprimé (200) possède au moins un trou acoustique (130a) passant à travers la carte de circuit imprimé (200).
